# FASCICULE DE BREVET EUROPEEN

(11) **EP 0 844 666 B1**
(45) Date de publication et mention de la délivrance du brevet: **01.03.2006**
(21) Numéro de dépôt: 97402744.3
(22) Date de dépôt: 17.11.1997
(51) Int. Cl.: H01L 25/10, H01L 25/065, H01L 25/07

(54) **Assemblage de modules électroniques multi-niveaux**
Zusammenbau elektronischer Moduln mit mehreren Ebenen
Electronic multi-level modules assembly

(30) Priorité: 21.11.1996 FR 9614208
(43) Date de publication de la demande: 27.05.1998
(73) Titulaire: ALCATEL, 75008 Paris (FR)
(72) Inventeur: Drevon, Claude, 31500 Toulouse (FR); Belin, Jean-Jacques, 31170 Tournefeuille (FR)
(74) Mandataire: Lamoureux, Bernard

(56) Documents cités:
- EP-A- 0 706 219
- WO-A-94/13121
- FR-A- 2 688 629
- US-A- 4 283 754

## Description

La présente invention concerne de manière générale un assemblage de modules électroniques. Cet assemblage comprend une pluralité de modules électroniques supportés par une structure porteuse.

Chaque module électronique est sous la forme de composants électroniques empilés sur au moins deux niveaux qui sont séparés entre eux par une couche diélectrique intermédiaire. A titre d'exemple non limitatif, le brevet américain US-A-5 309 122 et la demande de brevet français N°96 04249 proposent chacun un type particulier de module électronique.

Le brevet américain US-A-4 987 425 propose un assemblage de modules électroniques formant une antenne à éléments rayonnants. L'assemblage utilise une structure porteuse réalisée en un matériau de fibre de carbone qui est métallisé sur sa surface pour assurer une fonction d'écran de blindage et d'évacuation de chaleur. Cette structure porteuse définit une pluralité de cellules élémentaires disposées matriciellement à la manière d'un "nid d'abeilles". Les modules électroniques sont disposés à l'intérieur de ces cellules. Sur sa surface supérieure, la structure porteuse supporte un corps d'antenne sur lequel sont fixés des éléments rayonnants. Chaque élément rayonnant rayonne en réponse à la réception d'un signal de sortie produit par un module électronique. La surface inférieure de la structure porteuse définit un fond supportant des éléments de liaison conducteurs propres à appliquer des signaux d'entrée aux modules électroniques.

Un premier inconvénient de l'assemblage décrit dans ce brevet américain US-A-4 987 425 est de recourir à une structure porteuse relativement volumineuse. En outre, la réduction du poids de la structure porteuse implique l'utilisation d'un matériau en fibre de carbone qui est recouvert d'une couche métallique. Cette étape de métallisation augmente la difficulté de réalisation de la structure porteuse. Par ailleurs, l'évacuation thermique de la chaleur produite par les modules électroniques n'est pas optimale.

Le document US-4,283,754 pose le problème de l'évacuation de la chaleur générée par des circuits intégrés. Il décrit un arrangement de circuits intégrés portés par des plaques formant des empilages. Les plaques sont en métal et un conduit de fluide est disposé le long de l'empilage en contact thermique avec les bords des plaques.

Un premier objectif de l'invention est de fournir un assemblage de modules électroniques dont la structure porteuse est moins volumineuse et de réalisation plus simple que dans la technique antérieure. Un autre objectif de l'invention est d'offrir un assemblage offrant une meilleure évacuation thermique que dans la technique antérieure.

A cette fin, un assemblage de modules électroniques comprenant une pluralité de modules électroniques supportés par une structure porteuse, dans lequel
chacun des modules électroniques est sous la forme de .composants électroniques empilés sur au moins deux niveaux qui sont séparés entre eux par une couche intermédiaire, et
les modules électroniques comprennent chacun au moins un trou formé dans une couche intermédiaire, est caractérisé selon l'invention en ce que
la structure porteuse comprend au moins un élément de tige qui est introduit dans des trous respectifs de modules successifs.

Selon une réalisation, ledit au moins un élément de tige est rectiligne et est introduit dans des trous respectifs de modules successifs qui sont alignés.

Selon une autre réalisation, chaque élément de module comprend deux trous formés orthogonalement, les modules sont disposés matriciellement, et au moins un premier élément de tige est introduit dans des trous successifs respectifs de modules électroniques disposés en ligne, et au moins un second élément de tige est introduit dans des trous successifs respectifs de modules électroniques disposés en colonne.

En outre, les éléments de tige peuvent supporter des éléments de plaque de séparation de modules. Ces éléments de plaque assurent une fonction de blindage électromagnétique entre composants.

Avantageusement, les éléments de tige sont en un matériau à conductivité thermique élevée, et peuvent être couplés à un système d'évacuation thermique.

D'autres caractéristiques et avantages de la présente invention apparaîtront plus clairement à la lecture de la description suivante, en référence aux dessins annexés correspondants, dans lesquels:
- la figure 1 est une vue en perspective d'un module électronique selon l'invention;
- la figure 2 est une vue en coupe du module de la figure 1;
- la figure 3 est vue éclatée d'un assemblage de module électronique selon une variante de l'invention; et
- la figure 4 est une vue en coupe partielle d'un module électronique selon une variante de l'invention.

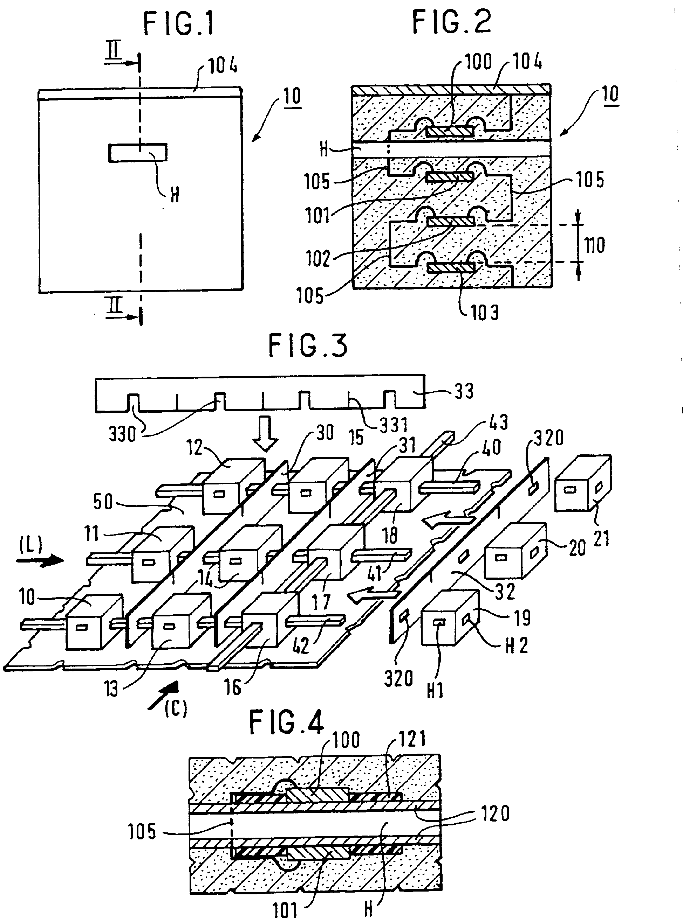

En référence aux figures 1 et 2, un module électronique multi-niveaux 10 est sous la forme de composants électroniques 100, 101, 102 et 103 empilés sur au moins deux niveaux. Deux composants électroniques, tels que 102 et 103, situés à deux niveaux respectifs sont séparés entre eux par une couche intermédiaire 110, typiquement en matériau diélectrique. Sur l'une des faces du module électronique 10, peut être fixé un élément rayonnant 104 dans le cas ou l'assemblage est destiné à formé partie d'une antenne active. Les composants situés à des niveaux différents sont reliés entre eux au moyen de liaison 105. Une liaison est par exemple réalisée au moyen d'une ligne coplanaire tel que cela est décrit dans la demande de brevet français ayant le numéro de dépôt N°96-04249, un via métallisé, etc..

Selon l'invention, chaque module de l'assemblage comprend au moins un trou H formé dans une couche intermédiaire diélectrique 110. Ce trou H est tel qu'il ne croise pas une liaison 105, comme cela est montré dans la figure 2. Comme cela apparaîtra de manière évidente par la suite, dans le cas d'un module situé à une extrémité de l'assemblage, ce trou H peut être un trou borgne, et dans les autres cas, ce trou est typiquement un trou débouchant traversant le module 1 de part en part.

En référence à la figure 3, selon l'invention, la structure porteuse comprend au moins un élément de tige, tel que l'élément de tige 40 qui est introduit dans des trous H respectifs de modules successifs. Pour l'élément de tige 40, ces modules sont désignés par 12, 15 et 18. Il peut être envisagé que l'assemblage ne comprend que des modules électroniques disposés en ligne. Dans ce cas, un seul élément de tige est prévu. Cet élément de tige est rectiligne et est introduit dans les trous respectifs de modules successifs qui sont alignés. L'assemblage comprend typiquement un circuit imprimé 50 recevant l'une des faces de chacun des modules.

En pratique, pour des applications aux antennes actives, les modules sont disposés matriciellement comme cela apparaît dans la figure 3. Dans ce cas, chaque module 10 à 21 comprend deux trous H1 et H2 qui sont portés par deux axes respectifs orthogonaux entre eux, et décalés entre eux. Ces deux trous sont disposés de telle sorte qu'ils ne croisent pas une liaison 105 et ne se croisent pas entre eux. Des premiers éléments de tige 40, 41 et 42 sont chacun introduit dans des trous successifs respectifs de modules électroniques disposés en ligne (L) 12-15-18, 11-14-17 et 10-13-16, et des seconds éléments de tige 43 sont chacun introduits dans des trous successifs respectifs de modules électroniques disposés en colonne (C) 16-17-18.

Avantageusement, des éléments de plaque de séparation et de blindage 30, 31, 32 et 33 peuvent être prévus de sorte notamment à isoler électromagnétiquement chaque module donné du ou des module (s) adjacent (s) . Pour cela, les éléments de plaque de séparation et de blindage 30, 31, 32 et 33 sont chacun munis de fente(s) et/ou trou(s) qui permettent leur fixation sur les éléments de tige 40, 41, 42 et 43. Selon la réalisation illustrée dans la figure 3, chaque plaque de séparation en colonne 30, 31 et 32 est munie de N=3 trous 320 destinés à recevoir respectivement les N premiers éléments de tige 40, 41 et 42. Chaque premier élément de tige, tel que 40, traverse donc successivement un trou H2 d'un module 18, un trou 320 d'une plaque de séparation 31, un trou H2 d'un module 15, et ainsi de suite. Par ailleurs, chaque plaque de séparation en ligne 33 est munie de fentes 330, 331 dans chacune desquelles un chant d'un second élément de tige 43 et/ou d'une plaque de séparation en colonne 30, 31 et 32 est introduit.

En vue d'assurer une évacuation maximale de la chaleur dégagée par le(s) composant(s) de chaque module, chaque élément de tige 40, 41, 42 et 43 assure une fonction de drain thermique. Pour cela, avantageusement, les éléments de tige sont en un matériau à conductivité thermique élevée. En outre, en variante, tous les éléments de tige 40, 41, 42 et 43 sont creux et sont couplés à un système d'évacuation thermique (non représenté). Ce système d'évacuation thermique assure une fonction de circulation d'un fluide d'échange thermique dans les éléments de tige 40, 41, 42 et 43.

Comme montré dans la figure 4, il peut par ailleurs être prévu que pour deux niveaux de composants électroniques 100 et 101, les composants de ces deux niveaux sont montés sur un matériau dissipatif 120 à bonne conductivité thermique. Par exemple, le circuit imprimé 50 est typiquement formé en ce matériau. Ce matériau 120 délimite ainsi deux faces du trou H recevant un élément de tige. L'élément de tige est monté dans ce trou H en contact avec le matériau 120 de sorte à assurer une évacuation thermique optimisée.

L'invention décrite ci-dessus s'applique par exemple aux antennes rayonnantes.

## Revendications

1. Assemblage de modules électroniques comprenant une pluralité de modules électroniques (10-21) supportés par une structure porteuse, dans lequel
chacun desdits modules électroniques (10-21) est sous la forme de composants électroniques(110-103) empilés sur au moins deux niveaux qui sont séparés entre eux par une couche intermédiaire (110) , et
lesdits modules électroniques comprennent chacun au moins un trou (H; H1, H2) formé dans une couche intermédiaire, **caractérisé en ce que**
ladite structure porteuse comprend au moins un élément de tige (40-43) qui est introduit dans des trous respectifs de modules successifs.

2. Assemblage conforme à la revendication 1, **caractérisé en ce que** ledit au moins un élément de tige (40-43) est rectiligne et est introduit dans des trous respectifs de modules successifs qui sont alignés.

3. Assemblage conforme à la revendication 2, **caractérisé en ce que** chaque élément de module comporte deux trous (H1, H2) formés orthogonalement, lesdits modules sont disposés matriciellement, et au moins un premier élément de tige est introduit dans des trous successifs respectifs de modules électroniques disposés en ligne (L), et au moins un second élément de tige est introduit dans des trous successifs respectifs de modules électroniques disposés en colonne (C) .

4. Assemblage conforme à la revendication 3, **caractérisé en ce que** lesdits éléments de tige supportent des éléments de plaque de séparation de modules.

5. Assemblage conforme à l'une quelconque des revendications précédentes, **caractérisé en ce que** lesdits éléments de tige sont en un matériau à conductivité thermique élevée.

6. Assemblage conforme à l'une quelconque des revendications précédentes, **caractérisé en ce que** lesdits éléments de tige sont creux pour recevoir un fluide d'échange thermique.

7. Assemblage conforme à la revendication 5 ou 6, **caractérisé en ce que** lesdits composants électroniques empilés sur lesdits deux niveaux sont chacun monté sur un matériau à bonne conductivité thermique qui délimite au moins en partie ledit trou recevant ledit élément de tige.

8. Antenne comprenant un assemblage conforme à l'une quelconque des revendications précédentes.

## Patentansprüche

1. Einheit aus Elektronikmodulen, bestehend aus einer Vielzahl an Elektronikmodulen (10-21), die auf einer Haltekonstruktion getragen sind, in der
- jedes der genannten Elektronikmodule (10-21) in Form von elektronischen Bauteilen (110-103) vorliegt, die in mindestens zwei Ebenen übereinander gestapelt sind, die durch eine Zwischenschicht (110) voneinander getrennt sind,
- die genannten Elektronikmodule jeweils mindestens ein Loch (H, H1, H2) beinhalten, das in einer Zwischenschicht gebildet wird, und
**dadurch gekennzeichnet, dass** die genannte Haltekonstruktion mindestens ein Stabelement (40-43) umfasst, das in die jeweiligen Löcher der übereinander gestapelten Module eingeführt wird.

2. Einheit gemäß Anspruch 1, **dadurch gekennzeichnet, dass** das genannte, mindestens eine Stabelement (40-43) geradlinig ist und in die jeweiligen Löcher der aufeinander folgenden Module eingeführt wird, die in einer Linie ausgerichtet sind.

3. Einheit gemäß Anspruch 2, **dadurch gekennzeichnet, dass** jedes Modulelement zwei orthogonal angeordnete Löcher (H1, H2) umfasst, wobei die genannten Module in Form einer Matrix angeordnet sind, und mindestens ein erstes Stabelement in die aufeinander folgenden Elektronikmodule, die in einer Linie (L) angeordnet sind, eingeführt wird, und mindestens ein zweites Stabelement in die jeweils aufeinander folgenden Löcher der in einer Säule (C) angeordneten Elektronikmodule eingeführt wird.

4. Einheit gemäß Anspruch 3, **dadurch gekennzeichnet, dass** auf den genannten Stabelementen Plattenelemente zur Trennung der Module getragen sind.

5. Einheit gemäß einem der vorgenannten Ansprüche, **dadurch gekennzeichnet, dass** die genannten Stabelemente aus einem Material mit erhöhter Wärmeleitfähigkeit bestehen.

6. Einheit gemäß einem der vorgenannten Ansprüche, **dadurch gekennzeichnet, dass** die genannten Stabelemente hohl sind, um eine Wärmetauschflüssigkeit aufzunehmen.

7. Einheit gemäß einem der Ansprüche 5 oder 6, **dadurch gekennzeichnet, dass** die genannten, in zwei Ebenen aufeinander gestapelten elektronischen Bauteile jeweils auf einem Material mit guter Wärmeleitfähigkeit montiert sind, das das genannte Loch, das das genannte Stabelement aufnimmt, zumindest teilweise einfasst.

8. Antenne, die eine Einheit gemäß einem der vorgenannten Ansprüche beinhaltet.

## Claims

1. Assembly of electronic modules comprising a plurality of electronic modules (10-21) supported by a support structure, wherein:
- each of said electronic modules (10-21) is in the form of electronic components (110-103) stacked on two or more levels that are separated from each other by an intermediate layer (110), and
- said electronic modules each comprise one or more holes (H, H1, H2) formed in an intermediate layer,
which assembly is **characterized in that** said support structure comprises one or more rod members (40-43) inserted into respective holes of successive modules.

2. Assembly according to claim 1, **characterized in that** the or each rod member (40-43) is rectilinear and is inserted into respective aligned holes of successive modules.

3. Assembly according to claim 2, **characterized in that** each module member includes two orthogonal holes (H1, H2), said modules are disposed in a matrix with one or more first rod members inserted into respective successive holes of electronic modules disposed in rows (L) and one or more second rod members inserted into respective successive holes of electronic modules disposed in columns (C).

4. Assembly according to claim 3, **characterized in that** said rod members support module separator plate members.

5. Assembly according to any one of the preceding claims, **characterized in that** said rod members are made from a material of high thermal conductivity.

6. Assembly according to any one of the preceding claims, **characterized in that** said rod members are hollow to receive a heat exchange fluid.

7. Assembly according to claim 5 or claim 6, **characterized in that** said electronic components stacked on said two levels are each mounted on a material of good thermal conductivity which at least partly delimits said hole receiving said rod member.

8. Antenna comprising an assembly according to any one of the preceding claims.
